# EUROPEAN PATENT APPLICATION

(11) **EP 2 849 219 A1**
(43) Date of publication of application: **18.03.2015**
(21) Application number: 13183985.4
(22) Date of filing: 11.09.2013
(51) Int. Cl.: H01L 21/8258, H01L 21/8238, H01L 27/092, H01L 29/66, H01L 29/04

(54) **Method for manufacturing transistors and associated substrate**

(71) Applicant: IMEC VZW, 3001 Leuven (BE)
(72) Inventor: Waldron, Niamh, B-3001 Leuven (BE); Witters, Liesbeth, B-3001 Leuven (BE)
(74) Representative: Bird Goën & Co

(57) **Abstract**

A method for manufacturing a CMOS device, comprising providing a starting substrate, the starting substrate comprising a silicon substrate the surface of which is oriented along the (100) crystal plane;
- forming shallow trench isolation structures in a first predetermined region, thereby defining channel areas in said substrate embodied as silicon protrusions extending from said silicon substrate and being isolated from each other by means of isolation structures;
- removing said silicon protrusions, thereby creating trenches;
- filling said trenches by epitaxially growing a III-V material in said trenches, to thereby form channel structures of transistors of a first type which are essentially defect-free; and associated substrate.

## Description

### Technical field

The present disclosure relates to the field of semiconductor processing.

It relates to a method for combining two different channel materials, both channel materials having different lattice constants than silicon and the channel materials respectively being part of transistor devices of different conductivity, on a common silicon substrate.

It also relates to an associated substrate.

### Background art

Different semiconductor channel materials are preferred on the same silicon substrate for CMOS high mobility device integration. Typical examples are strained or relaxed Germanium and III-V channel materials.

Hetero-epitaxial growth of semiconductors usually suffers from strain relaxation dislocation formation due to the difference (mismatch) of lattice parameters of the materials involved.

A solution proposed in literature is the selective growth of semiconductor in narrow oxide trenches, by means of the so-called Aspect Ratio Trapping (ART) technique. The ART technique permits trapping of all defects at the bottom of the trenches using the oxide trenches sidewalls. The top part of the semiconductor grown in the trench should then be relaxed without defects. An example wherein the ART technique is applied is described is for instance patent application US20100216277.

The state of the art ART technique can only be applied with narrow and short trenches, since only in these trenches it can form defect free relaxed semiconductors. However, for various applications such as for instance advanced logic CMOS devices and photonic devices, relatively long trenches are often required.

### Summary of the disclosure

It is an aim of the present disclosure to provide a method for manufacturing a CMOS device, the CMOS device comprising transistor devices of different conductivity types, which allows integration of transistor devices which comprise channel materials which have different lattice constants, and whereby these different lattice constants of the respective channel materials are different from the lattice constant of an underlying silicon substrate, on which the transistor devices are formed.

This aim is achieved according to the disclosure with a method showing the technical characteristics of the first independent claim.

It is a further aim to provide an associated substrate.

This aim is achieved according to the disclosure with the substrate showing the technical characteristics of the second independent claim.

According to an aspect of the present invention, a method for manufacturing a CMOS device comprises:
- providing a starting substrate, the starting substrate comprising a silicon substrate (or first semiconductor layer) the surface of which is oriented along the (100) crystal plane;
- forming shallow trench isolation structures in a first predetermined region, thereby defining channel areas in the substrate embodied as silicon protrusions extending from the silicon substrate and being isolated from each other by means of said shallow trench isolation structures;
- removing the silicon protrusions, thereby creating trenches;
- filling the trenches by epitaxially growing a III-V material in the trenches, to thereby form channel structures of transistors of a first type which are essentially defect-free (for instance having a defect density smaller than 1e5 defects/cm2).

According to an aspect of the present invention, the method comprises
- providing a starting substrate, the starting substrate comprising a silicon substrate (constituting a first semiconductor layer) the surface of which is oriented along the (100) crystal plane; a dielectric bonding layer on top of the surface, and a second semiconductor layer, the second semiconductor layer being bond to the silicon substrate by means of the dielectric bonding layer and having a lattice constant which is different from the lattice constant of the silicon substrate;
- removing a first portion of the second semiconductor layer and the dielectric bonding layer in a first predetermined region for forming a transistor device of a first type, thereby exposing the underling silicon substrate, and thereby leaving a second portion of the second semiconductor layer (and a corresponding second portion of the dielectric bonding layer) in a second predetermined region for forming a transistor device of a second type;
- forming shallow trench isolation structures in the first region, thereby defining channel areas in the substrate embodied as silicon protrusions extending from the silicon substrate and being isolated from each other by means of isolation structures;
- removing the silicon protrusions, thereby creating trenches;
- filling the trenches by epitaxially growing a III-V material in the trenches, to thereby form channel structures of transistors of a first type which are essentially defect-free;
- patterning the second semiconductor layer in the second predetermined region, to thereby form channel structures of transistors of a second type.

The respective transistor devices are preferably having channel materials which have different lattice constants, and these different lattice constants of the respective channel materials are preferably different from the lattice constant of an underlying silicon substrate.

The transistor devices of the first and second type are preferably transistor device of the n-type and of the p-type respectively, or vice versa.

The first and second predetermined regions are preferably adjacent.

It is known to the skilled person how to form shallow trench isolation structures in the first predetermined region.

According to preferred embodiments of the present disclosure, the second semiconductor layer comprises Germanium, Silicon Germanium, Germanium-Tin and/or III-V materials, or any combination of these materials.

According to preferred embodiments of the present disclosure, the second semiconductor layer consists of Germanium.

According to preferred embodiments of the present disclosure, a stress level of the second semiconductor layer is between -5GPa and +5GPa.

According to preferred embodiments, epitaxially growing a III-V material in the trenches to form channel structures of transistors of a first type, comprises growing a III-V material layer or stack comprising e.g. InP, InₓAl₁₋ₓAs, InₓGa₁₋ₓAs, InₓGa₁₋ₓSb, AlₓGa₁₋ₓSb, AlₓGa₁₋ₓSb(As), GaN or any combination thereof.

According to preferred embodiments of the present disclosure, the dielectric bonding layer comprises or consists of silicon oxide, silicon nitride, aluminium oxide or any combination thereof.

According to preferred embodiments of the present disclosure, the silicon protrusions have a width smaller than 20 nm, or smaller than 10nm, or smaller than 3nm. According to preferred embodiments of the present disclosure, removing the silicon protrusions, thereby creating trenches comprises creating trenches with a depth larger than 150% of its width, for instance trenches with a depth of about twice its width, or trenches with a depth larger than twice its width. For instance, for trenches with a width of 20 nm, the depth can be about 40 nm or larger.

According to preferred embodiments of the present disclosure, the temperature is kept below 600°C.

According to another aspect of the present invention, an associated substrate is disclosed comprising a silicon substrate the surface of which is oriented along the (100) crystal plane; a dielectric bonding layer on top of the surface, and a second semiconductor layer, the second semiconductor layer being bond to the silicon substrate by means of the dielectric bonding layer and having a lattice constant which is different from the lattice constant of the silicon substrate.

According to preferred embodiments of the present disclosure, the second semiconductor layer comprises Germanium, Silicon Germanium, Germanium-Tin and/or III-V materials, or any combination of these materials.

According to preferred embodiments of the present disclosure, the dielectric bonding layer comprises silicon oxide, silicon nitride, aluminium oxide or any combination thereof.

The substrate can further comprise features corresponding to features described in relation to the method aspects of the present invention, as will be understood by the skilled person.

### Brief description of the drawings

The disclosure will be further elucidated by means of the following description and the appended figures.

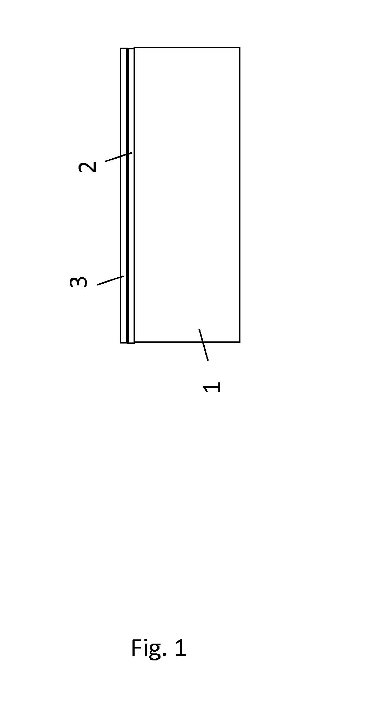

Figure 1 illustrates a substrate according to an embodiment of the first aspect of the present invention.

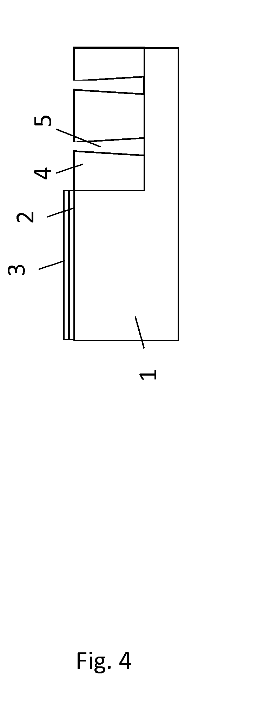

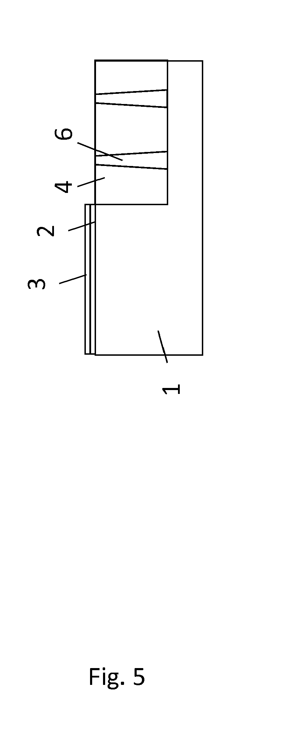

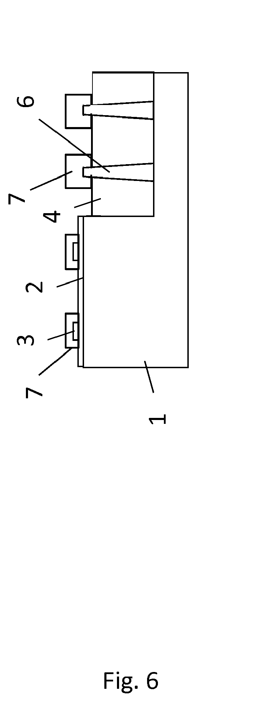

Figures 1 to 6 illustrate a process flow according to a second and third aspect of the present invention.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

The present disclosure relates to a method for dual material channel integration on a silicon substrate. Hereby, one of the semiconductor materials is provided essentially defect free, by using a hetero-epitaxial growth.

An aspect of the present invention is related to a specific starting substrate, comprising a specific layer stack. The substrate starting material stack has been depicted in Figure 1. The bottom or lower layer of the stack 1 consists of or comprises a silicon substrate (e.g. a silicon wafer) 1, the surface of which is oriented along the (100) crystal plane. The silicon substrate or wafer preferably comprises a notch oriented in the <100> direction (also known to the skilled person as a 45-degree (45°) rotated notch silicon substrate), onto which a second semiconductor layer 3 is bound by means of an intermediate dielectric bonding layer 2.

The material of the second semiconductor layer can for instance comprise or consist of Germanium, Silicon Germanium, Germanium-Tin and/or III-V materials, or any combinations of these materials. The intrinsic stress level within the second semiconductor layer is preferably in the range between -5 to +5 GPa. The second channel layer can be a strained or relaxed Ge layer.

The intermediate dielectric bonding layer 2 can for instance be or comprise silicon oxide, silicon nitride, aluminium oxide or any combination thereof. It can be any dielectric layer 2 that allows for a mechanical bonding between the silicon bottom layer and the top material while providing electrical isolation between both layers 1 and 3.

The specific substrate described above for a first aspect of the present invention can advantageously be used in a method for manufacturing transistor devices comprising III-V materials on a silicon substrate, according to a second aspect of the present invention.

It will be appreciated by the skilled person that the method above according to a second aspect of the present invention is particularly useful for manufacturing CMOS devices on a silicon substrate, as presented in a third aspect of the present invention. When producing CMOS devices, two different channel materials are used, both channel materials having different lattice constants than silicon and the channel materials respectively being part of transistor devices of different conductivity, for instance being respectively of the NMOS type and PMOS type, on a common silicon substrate.

Such a CMOS process flow will now be described in detail, whereby the above mentioned second and third aspects of the present invention are illustrated.

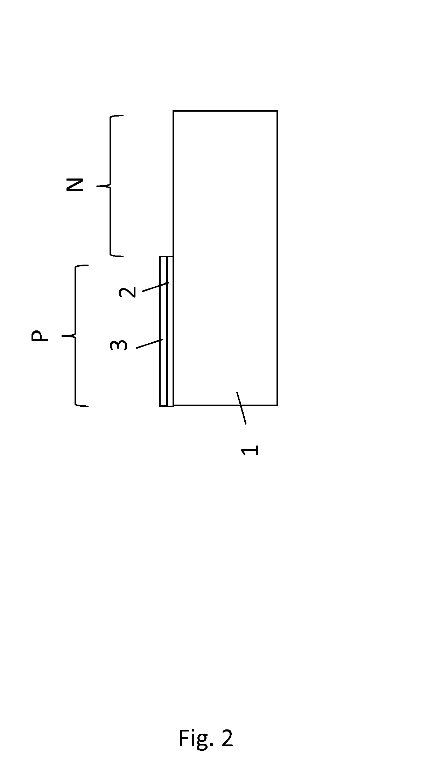

In the first step of the processing flow, depicted in Figure 2, the second semiconductor layer 3 is patterned selectively towards the intermediate dielectric bonding layer 2 or the silicon substrate layer 1 in the area where the first semiconductor channel structure and its isolation are to be provided afterwards (called n-FET region N in figure 1).

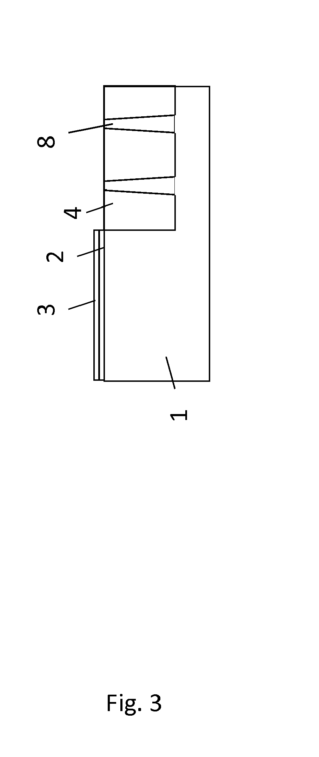

In aspects of the present invention, illustrated in figure 3, active narrow silicon structures or protrusions extending from the silicon substrate, having a width smaller than 20nm are patterned and isolated in the n-FET region by using a silicon STI (Shallow Trench Isolation) process flow as it is known to the skilled person.

A silicon STI process flow can for instance comprise or consists of the following steps:
- perform lithography and etching processes to create trenches with silicon areas in between the trenches, the silicon areas corresponding to the protrusions extending from the silicon substrate;
- filling the created trenches with an insulating material such as for instance a silicon oxide;
- performing a planarization process as for instance a Chemical Mechanical Polishing (CMP) process for planarizing the surface, resulting in the silicon areas (protrusions) being separated by silicon oxide areas 4.

According to preferred embodiments of the present invention, the silicon areas or protrusions 8 defined in the STI oxide have a width which is smaller than 20nm, and have a depth which is preferably larger than 40nm. This allows benefiting from an aspect ratio trapping effect during subsequent epitaxial growth of material of the channel structure in the n-FET region, as will be described below. Preferably, temperature constraints are taken into account, such that the quality of the second semiconductor layer 3 is not compromised during the STI processing. The temperature is therefore preferably kept below 600°C.

Afterwards, the method according to the second and third aspects of the present invention of the invention comprises partially removing the narrow silicon areas defined in the STI oxide to a depth larger than 40nm in the n-FET region, creating trenches 5, and refilling the trenches 5 by a semiconductor channel structure 6 (e.g. corresponding to a FIN structure of a N-FET device) by epitaxially growing a channel material (for instance a III-V material stack comprising e.g. InP, InₓAl₁₋ₓAs, InₓGa₁₋ₓAs, InₓGa₁₋ₓSb, AlₓGa₁₋ₓSb, AlₓGa₁₋ₓSb(As),GaN or any combination thereof to create a heterostructure stack) having a lattice constant different from the lattice constant of silicon. The cavities can be overfilled or overgrown by growing channel material over adjacent STI isolation structures, and the epitaxially grown material which overgrew the STI isolation structures can then subsequently be removed, for instance by CMP. Alternatively, the trenches 5 can be filled by the epitaxially grown material without overgrowing the STI area.

The material of the semiconductor channel structure 6 is preferably a crystalline material with a different lattice constant than the lattice constant of the silicon substrate 1.

Due to the orientation of the silicon substrate 1 along the (100) crystal plane and the <100> direction, the limitation of the width of the cavity 5 to maximum 20nm, and the minimal depth of 40nm of the trench 5 described above, all (111) oriented facets which are formed during the growth are trapped on or at the trench sidewall. Preferably, the trench depth can be about twice the trench width or can be larger than twice the trench width. The depth, width and orientation of the trenches is such that defects generated in the epitaxially grown layer of the material of the semiconductor structure 6 at the substrate portion at the bottom of the trench 5, which propagate in the (111) direction, are trapped by the trench sidewalls. Preferably, the temperature is kept below 600°C during the growth of the material of the semiconductor channel structure 6, so as to not impact the quality of the second semiconductor layer 3 during this processing.

In a further step of fabricating a suitable dual channel structure for CMOS device fabrication, the remaining part of the second semiconductor layer 3 is subsequently patterned to provide the appropriate channel structure, for instance FIN structure of a P-FET transistor device, in the p-FET region P as depicted in figure 1, for the targeted device fabrication using material of the second semiconductor layer 3 as channel or active layer material.

Gate structures 7 can then be provided on the respective semiconductor channel structures, according to processes known to the skilled person.

The skilled person will recognize that temperature constraints apply, as the quality of the channel materials 1 and/or 2 during the above described processing should not be impacted.

It will be appreciated by the skilled person that the method and associated substrate of aspects of the present invention allow dual material channel integration on a silicon substrate. Hereby, for instance the III-V material of the semiconductor structures 6, which are preferably channel structures of transistor devices of the n-type, preferably of the FINFET type, can be provided essentially defect free, by using a hetero-epitaxial growth on the silicon substrate with predetermined suitable orientation. At the same time Germanium based p-type transistors, preferably of the FINFET type, can be integrated on the same wafer.

## Claims

1. A method for manufacturing a CMOS device, comprising
- providing a starting substrate, the starting substrate comprising a silicon substrate the surface of which is oriented along the (100) crystal plane;
- forming shallow trench isolation structures in a first predetermined region, thereby defining channel areas in said substrate embodied as silicon protrusions extending from said silicon substrate and being isolated from each other by means of said shallow trench isolation structures;
- removing said silicon protrusions, thereby creating trenches;
- filling said trenches by epitaxially growing a III-V material in said trenches, to thereby form channel structures of transistors of a first type which are essentially defect-free.

2. A method for manufacturing a CMOS device according to claim 1, comprising
- providing said starting substrate, said starting substrate comprising a silicon substrate the surface of which is oriented along the (100) crystal plane; a dielectric bonding layer on top of said surface, and a second semiconductor layer, said second semiconductor layer being bond to said silicon substrate by means of said dielectric bonding layer and having a lattice constant which is different from the lattice constant of said silicon substrate;
- removing a first portion of said second semiconductor layer and said dielectric bonding layer in said first predetermined region for forming a transistor device of a first type, thereby exposing said underling silicon substrate, and thereby leaving a second portion of said second semiconductor layer in a second predetermined region for forming a transistor device of a second type;
- forming shallow trench isolation structures in said first region, thereby defining channel areas in said substrate embodied as silicon protrusions extending from said silicon substrate and being isolated from each other by means of isolation structures;
- removing said silicon protrusions, thereby creating trenches;
- filling said trenches by epitaxially growing a III-V material in said trenches, to thereby form channel structures of transistors of a first type which are essentially defect-free;
- patterning said second semiconductor layer in said second predetermined region, to thereby form channel structures of transistors of a second type.

3. Method according to claim 2, wherein said second semiconductor layer comprises Germanium, Silicon Germanium, Germanium-Tin and/or III-V materials, or any combination of these materials.

4. Method according to claim 3, wherein said second semiconductor layer consists of Germanium.

5. Method according to claims 3 or 4, wherein a stress level of said second semiconductor layer is between -5GPa and +5GPa.

6. Method according to any of the previous claims, wherein said channel structures of transistors of a first type comprises a III-V material layer or stack comprising e.g. InP, InₓAl₁₋ₓAs, InₓGa₁₋ₓAs, InₓGa₁₋ₓSb, AlₓGa₁₋ₓSb, AlₓGa₁₋ₓSb(As), GaN or any combination thereof.

7. Method according to any of the previous claims 2 to 6, wherein said dielectric bonding layer comprises or consists of silicon oxide, silicon nitride, aluminium oxide or any combination thereof.

8. Method according to any of the previous claims, wherein said silicon protrusions have a width smaller than 20 nm.

9. Method according to any of the previous claims, wherein removing said silicon protrusions, thereby creating trenches comprises creating trenches with a depth larger than 150% of its width.

10. Method according to any of the previous claims, whereby the temperature is kept below 600°C.

11. A substrate comprising a silicon substrate the surface of which is oriented along the (100) crystal plane; a dielectric bonding layer on top of said surface, and a second semiconductor layer, said second semiconductor layer being bond to said silicon substrate by means of said dielectric bonding layer and having a lattice constant which is different from the lattice constant of said silicon substrate.

12. A substrate according to claim 11, wherein said second semiconductor layer comprises Germanium, Silicon Germanium, Germanium-Tin and/or III-V materials, or any combination of these materials.

13. A substrate according to claim 11 or 12, wherein said dielectric bonding layer comprises silicon oxide, silicon nitride, aluminium oxide or any combination thereof.
